# EUROPÄISCHE PATENTSCHRIFT

(11) **EP 1 426 119 B1**
(45) Veröffentlichungstag und Bekanntmachung des Hinweises auf die Patenterteilung: **04.10.2006**
(21) Anmeldenummer: 03026266.1
(22) Anmeldetag: 14.11.2003
(51) Int. Cl.: B05D 3/14, C23C 14/02, C23C 14/34

(54) **Plasmaverfahren zur Oberflächenbehandlung von Substraten aus Silikon**
Plasma surface treatment of silicone substrates
Traitement de surface par plasma de substrats de silicone

(30) Priorität: 03.12.2002 DE 10256483
(43) Veröffentlichungstag der Anmeldung: 09.06.2004
(73) Patentinhaber: hartec GmbH, 72510 Stetten a.k.M. (DE)
(72) Erfinder: Ribeiro, Carlos, Dipl.-Ing., 72469 Messstetten (DE); Schäfer, Rüdiger, Dr., 79865 Grafenhausen (DE)
(74) Vertreter: Strych, Werner Maximilian Josef

(56) Entgegenhaltungen:
- EP-A- 1 225 248
- US-A- 4 756 964
- US-A- 5 357 005
- US-A- 5 376 400

## Beschreibung

Die Erfindung betrifft ein Plasmaverfahren zur Oberflächenbehandlung von Substraten aus Silikon.

Die Oberflächen von Kunststoffen lassen sich durch herkömmliche Verfahren oft nicht lackieren, verkleben, beschäumen, metallisieren oder auf eine andere Art und Weise beschichten. Dies ist darauf zurückzuführen, dass Polymere oft hydrophob sind, d.h. niedrige Oberflächenenergien aufweisen. Zum Verbessern der Benetzbarkeit und der Adhäsionseigenschaften müssen die Kunststoffoberflächen deshalb mittels spezieller Verfahren vorbehandelt, d.h. aktiviert, werden. Unter dem Begriff "Aktivierung" versteht man dabei eine Erhöhung der Polarität bzw. der Oberflächenenergie, wodurch ein verbessertes Haftvermögen bzw. eine verbesserte Benetzbarkeit erreicht wird.

Beispiele für Verfahren zur Vorbehandlung von Oberflächen sind im Stand der Technik gut bekannt und umfassen nasschemische Oberflächenvorbehandlungsverfahren, wie beispielsweise Beizen, und physikalische Oberflächenvorbehandlungsverfahren, wie beispielsweise Beflammung (Pyrolyse), Fluorierung, Coronabehandlung und Plasmaverfahren.

Bei den zur Zeit überwiegend verwendeten herkömmlichen nasschemischen Verfahren werden die Kunststoffe zur Vorbehandlung mit aggressiven Oxidationsmitteln (meistens Chromschwefelsäure) gebeizt, um eine Aktivierung zu erreichen. Teilweise ist vorab noch ein Quellen der Kunststoffe unter Verwendung organischer Lösungsmittel (wie z.B. chlorierte Kohlenwasserstoffe) notwendig. Der grösste Nachteil der hier aufgeführten nasschemischen Prozessierung ist jedoch die aufwändige Reinigung und Entsorgung sowie die gesundheitliche Belastung des Personals. So muss ein hoher Anteil der verwendeten Chemikalien durch Abwasseraufbearbeitungsanlagen entfernt werden. Daneben müssen für die verschiedenen Kunststoffe auch unterschiedliche Beizlösungen verwendet werden (wie z.B.

Naphthylnatrium in Tetrahydrofuran für PTFE, Flusssäure für Polyimid). Ein weiteres Problem ist die teilweise zu starke Aufrauhung der Oberfläche infolge des Beizens, so dass manche Kunststoffe für dekorative Anwendungen nicht eingesetzt werden können.

Beim Beflammen wird die zu behandelnde Oberfläche mittels einer Gasflamme, die einen Sauerstoffüberschuss besitzt, kurzzeitig erhitzt, wodurch die Oberfläche so modifiziert wird, dass das Haftvermögen erhöht wird.

Bei der Fluorierung wird die Oberfläche des Bauteils bei Raumtemperatur einem Gasgemisch aus Stickstoff und wenigen Prozentanteilen Fluor und eventuell geringen Prozentanteilen Sauerstoff ausgesetzt, wobei in einem stark exothermen Prozess Wasserstoffatome in den äusseren Schichten des Polymers durch Fluoratome ersetzt werden. Durch den Austausch eines Teiles der Wasserstoffatome durch Fluoratome werden im Polymer Dipole erzeugt, die zu einer erhöhten Oberflächenenergie und somit besseren Benetzbarkeit führen.

Bei der Coronabehandlung wird hingegen mittels einer Elektrode ein Funkenregen auf die zu behandelnde Oberfläche aufgebracht, wodurch Ozon entsteht, das in die Oberfläche eingelagert wird. Dadurch wird wie bei allen Aktivierungsverfahren das Haftvermögen der meist unpolaren Kunststoffoberfläche erhöht.

Die Plasmaaktivierung spielt insbesondere bei der Aktivierung von Kunststoffen eine immer grössere Rolle, da die herkömmlichen nasschemischen Verfahren wie oben bereits beschrieben den Nachteil einer hohen Umweltbelastung (Einsatz von z.B. Chromschwefelsäure) aufweisen. Bei der Plasmaaktivierung wird ein Gas oder ein Gasgemisch (z.B. Argon, Sauerstoff, Stickstoff, Ammoniak etc.) einer elektrischen Gasentladung im Vakuum unterzogen und die dabei erzeugten Elektronen, Ionen, Radikale, Neutralteilchen prallen auf die Substratoberfläche. Dadurch können Kontaminationen entfernt, die Oberflächen aufgerauht und chemisch modifiziert werden. Die erhaltenen Modifikationen sind dabei abhängig vom verwendeten Gas. Verwendet man beispielsweise Sauerstoff, ist es möglich Polymere so zu modifizieren, dass Hydroxyl-, Carboxyl- oder Peroxidgruppen an der Oberfläche entstehen. Verwendet man dagegen Stickstoff oder Ammoniak, so führt das zu Aminoder Imin-Gruppen, welche für bestimmte Anwendungen ebenfalls interessant sein können. Durch die Erzeugung von polaren hydrophilen Gruppen erhöht sich die Energie und somit die Benetzbarkeit der Oberfläche des behandelten Bauteils.

Werden bei dem Plasmaverfahren zusätzlich gasförmige vernetzbare Monomere aus kettenbildenden Atomen, wie Kohlenstoff, Silicium oder Schwefel, in die Prozesskammer eingeleitet, werden diese durch das Plasma angeregt und schlagen sich auf der Substratoberfläche als hochvernetzte Schichten nieder. Durch dieses als Plasmapolymerisation (PECVD, plasma enhanced chemical vapor deposition) bezeichnete Verfahren können plasmapolymere Beschichtungen hergestellt werden, die beispielsweise als kratzresistente Beschichtungen, Korrosionsschutz, Barriereschichten und antihaftende, schmutzabweisende Beschichtungen verwendet werden können.

Die Vorteile der Plasmabehandlung liegen in dem sehr guten Haftvermögen, der Aktivierbarkeit auch solcher Kunststoffe, die beispielsweise nasschemisch nicht oder nicht wirtschaftlich zugänglich sind, der Freiheit bezüglich der Geometrie der Bauteile und der Art des Polymers, da die Temperatur während des Prozesses nicht signifikant ansteigt. Die Plasmabehandlung kann im Gegensatz zum Beflammen wiederholt werden und führt im Vergleich zum Beflammen und zur Coronabehandlung zu einer bedeutend höheren Gleichmässigkeit der Aktivierung. Ferner ist das Verfahren umweltfreundlich, da im Gegensatz zu den nasschemischen Verfahren keine ökologisch bedenklichen Stoffe, wie Chromschwefelsäure, zum Einsatz kommen. Überdies sind die Plasmaverfahren im Vergleich zu vielen Konkurrenzverfahren auch sehr kostengünstig, da keine Entsorgungskosten anfallen, kein Trockenvorgang nötig ist, der Verbrauch von Plasmagasen sehr gering ist und keine Haftgrundierung notwendig ist.

Die mit Hilfe der oben erwähnten Verfahren vorbehandelten Kunststoffoberflächen lassen sich durch eine Vielzahl von Verfahren, wie beispielsweise Bedrucken, Lackieren und PVD-Verfahren, wie thermisches Bedampfen und Sputtern, weiter verarbeiten. Durch die Beschichtung von Kunststoffbauteilen lassen sich die Vorteile von Polymerwerkstoffen (Kosten, Gewicht, Formgebung) mit den Eigenschaftsprofilen von metallischen und Hartstoffschichten kombinieren und die Bauteileigenschaften auf das Anforderungsprofil anpassen. Die Beschichtungsverfahren verleihen dem Bauteil die gewünschten mechanischen und chemischen Eigenschaften, wie Verschleissfestigkeit, Kratzfestigkeit und/oder ein ansprechendes Äusseres sowie eine angenehme Haptik. Typische Anwendungen umfassen leitfähige Schichten (z.B. Leiterplatten, Kondensatoren), Abschirmungen gegen elektromagnetische Strahlung (z.B. Computergehäuse, Mobiltelefone), dekorative Schichten (z.B. Badarmaturen), reflexierende Schichten (z.B. Scheinwerferrelektoren), verschleissbeständige Schichten (z.B. mechanische Übertragungsglieder, Helmvisiere) usw.

Das oben beschriebene Plasmaverfahren zur Aktivierung von Kunststoffoberflächen kann auch auf ein Substrat aus Silikon angewendet werden. Silikon ist ein sehr vielseitig einsetzbarer Werkstoff, der zudem im Allgemeinen physiologisch verträglich ist. Die durch herkömmliche Verfahren plasmaaktivierten Silikonsubstrate weisen jedoch nur eine geringe Halbwertszeit, d.h. die Zeit innerhalb der das Bauteil nach erfolgter Aktivierung weiterverarbeitet, z.B. lackiert, werden soll, von einigen Minuten bis Stunden auf. Des Weiteren ist die Reproduzierbarkeit und Kontrollierbarkeit der Plasmaaktivierung durch im Stand der Technik bekannte Verfahren begrenzt. Überdies können die durch ein Verfahren im Stand der Technik (z.B. US-A-5,376,400, EP-A-1,225,248, US-A-5,357,005) vorbehandelten Silikonsubstrate nicht direkt metallisiert werden. Vielmehr erfolgt vor dem Metallisieren ein Zwischenschritt wie beispielsweise eine Lackierung.

Der Erfindung liegt daher die Aufgabe zugrunde, ein Plasmaverfahren zur Oberflächenbehandlung von Substraten aus Silikon bereitzustellen, welches die direkte Weiterverarbeitung, wie beispielsweise Lackieren oder Metallisieren, mit guter Reproduzierbarkeit und Kontrollierbarkeit ermöglicht.

Diese Aufgabe wird erfindungsgemäss durch die Merkmale des Patentanspruchs 1 gelöst. Vorteilhafte Ausführungsformen der vorliegenden Erfindung sind in den abhängigen Ansprüchen beschrieben.

Das erfindungsgemässe Plasmaverfahrens ermöglicht überraschenderweise, dass die aktivierten Oberflächen von Silikonsubstraten für wenigstens einige Stunden bis über eine Woche aktiv bleiben. Ferner führt das erfindungsgemässe Plasmaverfahren unter Verwendung der unten aufgeführten Prozessparameter zu einem aktivierten Silikonsubstrat, das ohne weitere Schritte, z.B. Lackieren oder nasschemisches Bekeimen (Voraussetzung für eine elektrolytische Metallisierung), durch ein PVD-Verfahren, wie Bedampfen und Sputtern, metallisiert werden kann. Überdies ist das erfindungsgemässe Verfahren aufgrund der Art der Plasmaerzeugung gut reproduzierbar und kontrollierbar.

Die Vorteile einer Kunststoff-Metallisierung mittels eines PVD-Verfahrens liegen zum einen darin, dass nur zwei Prozessschritte, nämlich Aktivierung und Metallisierung, notwendig sind, die in einer Anlage direkt hintereinander durchgeführt werden können. Zudem erhält man sehr homogene Schichten. Zum anderen entfallen im Vergleich zu nasschemischen Verfahren die Kosten für die Entsorgung von toxischen Chemikalien.

In einem ersten Schritt des erfindungsgemässen Verfahrens wird das zu behandelnde Substrat aus Silikon in eine Prozesskammer eingebracht und für 3 bis 60 Min., vorzugsweise 10 bis 30 Min., bei einer Temperatur von 20 °C bis 100 °C, vorzugsweise von 30 °C bis 60 °C, und einem Druck von 10⁻⁵ bis 10⁻¹ mbar, vorzugsweise 10⁻⁴ bis 10⁻² mbar, ausgegast, wobei die Ausgasungen mittels Vakuumpumpen kontinuierlich aus der Prozesskammer abgepumpt werden.

Das zu behandelnde Substrat aus Silikon ist hinsichtlich seiner chemischen und physikalischen Eigenschaften auf keine Art und Weise eingeschränkt. Bevorzugt sind im Rahmen der vorliegenden Erfindung jedoch Substrate aus flexiblem Silikon, d.h. Feststoffsilikon (HTV) bzw. Flüssigsilikon (LSR), wie z.B. Dimethylsiloxan.

Die Oberfläche des Substrates wird dann in einem weiteren Schritt des erfindungsgemässen Verfahrens durch Ionen und/oder Elektronen, die durch eine elektrische Gasentladung im Vakuum erzeugt werden, beschossen. Der Druck in der Prozesskammer liegt dabei zwischen 10⁻³ und 10⁻² mbar. Bei diesen Drücken ist die mit der mittleren freien Weglänge korrelierte Energie der Plasmateilchen ausreichend gross, um an der Substratoberfläche zu chemischen Reaktionen zu führen, die bei niedrigen Temperaturen und Atmosphärendruck nicht möglich oder sehr unwahrscheinlich sind.

Als Gase für die Gasentladung werden Edelgase und gegebenenfalls Reaktivgase verwendet. Das Edelgas kann Ar, Ne, Kr und Xe sein, wobei Ar bevorzugt verwendet wird. Geeignete Reaktivgase umfassen Stickstoff-, Kohlenstoff- und Sauerstoffenthaltende Gase und Mischungen davon, vorzugsweise Stickstoff (N₂), Kohlendioxid (CO₂), Ethan (C₂H₆), Ethylen (C₂H₄), Acetylen (C₂H₂) und O₂, sind jedoch nicht darauf beschränkt. Die Gasatmosphäre in der Prozesskammer besteht im Wesentlichen aus 30 bis 100 Vol.-% eines der oben genannten Edelgase und 70 bis 0 Vol.-% eines der oben genannten Reaktivgase oder Mischungen davon. Bevorzugt ist eine Mischung aus 40 bis 80 Vol.-% Ar und 60 bis 20 Vol.-% eines Reaktivgases oder Mischungen davon, insbesondere 60 Vol.-% Ar, 20 Vol.-% Stickstoff und 20 Vol.-% eines Kohlenstoff-enthaltenden Gases, wie CO₂ und Acetylen.

Bei der Verwendung von Gasen, die keine Edelgase sind, wie Stickstoff oder Sauerstoff, werden die in ihnen enthaltenen Atome vermutlich in die Oberfläche des Silikonsubstrates eingebaut, wodurch beispielsweise Hydroxyl- und andere sauerstoffhaltige funktionelle Gruppen eingebaut werden. Die Verwendung von Ethylen oder Acetylen führt möglicherweise zu einem Vernetzen der kettenbildenden Kohlenstoffatome, welche sich in der Form eines Plasmapolymers auf der Oberfläche des Silikonsubstrates niederschlagen können.

Die Gasentladung kann eine DC- (Gleichstrom), AC- (Wechselstrom), HF-, RF- oder Mikrowellen-Gasentladung sein, wobei eine DC-Gasentladung bevorzugt ist. Die DC-Leistung beträgt 500 bis 3000 W je Plasmaquelle, vorzugsweise 1200 bis 2500 W.

Die Plasmaaktivierung wird im Allgemeinen bei einer Temperatur von 20 °C bis 100 °C, insbesondere 30 °C bis 60 °C, für eine Zeitdauer von 1 bis 30 Min., insbesondere 5 bis 15 Min., durchgeführt.

Die Erzeugung des Plasmas erfolgt beispielsweise mittels einer im Deutschen Patent DE 36 15 361 C2 beschriebenen Plasmaquelle ausserhalb der Prozesskammer. Dabei kann das Edelgas und das Reaktivgas, falls vorhanden, kontinuierlich in die Plasmaquelle eingeleitet werden, wo ein Plasma mittels einer Gasentladung erzeugt wird und dann durch eine Öffnung in die Prozesskammer und auf die zu behandelnde Substratoberfläche trifft, oder das Edelgas kann kontinuierlich in die Plasmaquelle eingeleitet werden, wo ein Plasma mittels einer Gasentladung erzeugt wird und dann durch eine Öffnung in die Prozesskammer gelangt, in die ein Reaktivgas, falls vorhanden, kontinuierlich zugeführt wird, wodurch das Reaktivgas ionisiert wird und das Edelgas/Reaktivgas-Plasma auf die Oberfläche des Silikonsubstrates auftrifft.

Das erfindungsgemässe Verfahren ist im Gegensatz zu herkömmlichen Verfahren, die auf Plasmaeinkopplungen beruhen, gut reproduzierbar und kontrollierbar, da die Oberfläche der Bauteile gleichmässig mit Plasma aus der Plasmaquelle bestrahlt werden.

Die Prozessparamter, wie die kinetische Energie der Teilchen, die verwendeten Gase, die Art der Gasentladung, die Einwirkdauer des Plasmas auf die Oberfläche des Substrats und der Druck in der Prozesskammer werden genau kontrolliert, wodurch eine spezifisch modifizierte Oberfläche des Silikonsubstrates mit charakteristischen Eigenschaften erhalten wird. Ein auf diese Art und Weise hergestelltes Silikonsubstrat weist beispielsweise eine signifikant höhere Oberflächenenergie, d.h. grösser als 35 mN/m bis über 55 mN/m, insbesondere grösser als 40 mN/m, auf. Die Oberflächenenergie kann durch einem Fachmann bekannte Verfahren, wie beispielsweise Messen des Kontaktwinkels, Verlaufen von Testtinten etc., bestimmt werden. Die mittels des Plasmaverfahrens der vorliegenden Erfindung aktivierten Oberflächen von Silikonsubstraten bleiben für einige Stunden bis über 5 Tage aktiv.

Die auf die oben beschriebene Art und Weise aktivierten und lackierten bzw. beschichteten Silikonsubstrate können für einer Vielzahl von Anwendungen verwendet werden, da sie gewünschte Oberflächeneigenschaften, wie z.B. metallischer Glanz, mit einer angenehmen Haptik vereinen. Beispiele für die Anwendungsgebiete solcher Bauteile mit "Softoberflächen" sind Kraftfahrzeuge, wie Tasten von Kfz-Lenkrädern, Telekommunikationsgeräte, wie Mobiltelefon- und Computertastaturen, Haushaltsgeräte, Badarmaturen und -zubehör, Küchenarmaturen und -zubehör, Schmuck- und andere Gebrauchsgegenstände. Ein weiteres Einsatzgebiet stellt die Medizintechnik dar, wo beispielsweise metallisierte Bauteile aus flexiblem Silikon als leitfähige und dennoch flexible Sonden eingesetzt werden können.

## Patentansprüche

1. Plasmaverfahren zur Oberflächenbehandlung von Substraten aus Silikon, wobei das zu behandelnde Substrat in eine Prozesskammer eingebracht wird, das Substrat ausgegast wird, die Ausgasungen mittels Vakuumpumpen kontinuierlich aus der Prozesskammer abgepumpt werden und das Substrat durch Plasmaaktivierung aktiviert wird, indem die Oberfläche des Substrats einem durch eine elektrische Gasentladung im Vakuum erzeugten Plasma ausgesetzt wird, wobei die Energie und die Einwirkdauer des Plasmas auf die Oberfläche des Substrats so gewählt wird, daß sich die Oberflächenenergie der Substratoberfläche aufgrund der Modifizierung von oberflächennahen Molekülen signifikant erhöht, wobei die auf diese Art und Weise oberflächenbehandelten Substrate aus Silikon direkt beschichtet werden können,
**dadurch gekennzeichnet, daß**
die Plasmaaktivierung bei einem Druck von 10⁻³ bis 10⁻² mbar erfolgt.

2. Plasmaverfahren zur Oberflächenbehandlung von Substraten aus Silikon nach Anspruch 1,
**dadurch gekennzeichnet, daß**
das Substrat aus flexiblem Silikon besteht.

3. Plasmaverfahren zur Oberflächenbehandlung von Substraten aus Silikon nach Anspruch 2,
**dadurch gekennzeichnet, daß**
das flexible Silikon Dimethylsiloxan ist.

4. Plasmaverfahren zur Oberflächenbehandlung von Substraten aus Silikon nach einem der Ansprüche 1 bis 3,
**dadurch gekennzeichnet, daß**
das Substrat bei einem Druck von 10⁻⁵ bis 10⁻¹ mbar ausgegast wird.

5. Plasmaverfahren zur Oberflächenbehandlung von Substraten aus Silikon nach Anspruch 4,
**dadurch gekennzeichnet, daß**
das Substrat bei einem Druck von 10⁻⁴ bis 10⁻² mbar ausgegast wird.

6. Plasmaverfahren zur Oberflächenbehandlung von Substraten aus Silikon nach einem der Ansprüche 1 bis 5,
**dadurch gekennzeichnet, daß**
das Substrat für eine Zeitdauer von 3 bis 60 Minuten ausgegast wird.

7. Plasmaverfahren zur Oberflächenbehandlung von Substraten aus Silikon nach Anspruch 6,
**dadurch gekennzeichnet, daß**
das Substrat für eine Zeitdauer von 10 bis 30 Minuten ausgegast wird.

8. Plasmaverfahren zur Oberflächenbehandlung von Substraten aus Silikon nach einem der Ansprüche 1 bis 7,
**dadurch gekennzeichnet, daß**
das Substrat bei einer Temperatur von 20 °C bis 100 °C ausgegast wird.

9. Plasmaverfahren zur Oberflächenbehandlung von Substraten aus Silikon nach Anspruch 8,
**dadurch gekennzeichnet, daß**
das Substrat bei einer Temperatur von 30 °C bis 60 °C ausgegast wird.

10. Plasmaverfahren zur Oberflächenbehandlung von Substraten aus Silikon nach einem der Ansprüche 1 bis 9,
**dadurch gekennzeichnet, daß**
die Plasmaaktivierung für eine Zeitdauer von 1 bis 30 Minuten erfolgt.

11. Plasmaverfahren zur Oberflächenbehandlung von Substraten aus Silikon nach Anspruch 10,
**dadurch gekennzeichnet, daß**
die Plasmaaktivierung für eine Zeitdauer von 5 bis 15 Minuten erfolgt.

12. Plasmaverfahren zur Oberflächenbehandlung von Substraten aus Silikon nach einem der Ansprüche 1 bis 11,
**dadurch gekennzeichnet, daß**
die Plasmaaktivierung bei einer Temperatur von 20 °C bis 100 °C erfolgt.

13. Plasmaverfahren zur Oberflächenbehandlung von Substraten aus Silikon nach Anspruch 12,
**dadurch gekennzeichnet, daß**
die Plasmaaktivierung bei einer Temperatur von 30 °C bis 60 °C erfolgt.

14. Plasmaverfahren zur Oberflächenbehandlung von Substraten aus Silikon nach einem der Ansprüche 1 bis 13,
**dadurch gekennzeichnet, daß**
die Gasentladung eine DC-, AC-, HF-, RF- oder Mikrowellen-Gasentladung ist.

15. Plasmaverfahren zur Oberflächenbehandlung von Substraten aus Silikon nach Anspruch 14,
**dadurch gekennzeichnet, daß**
die Gasentladung eine DC-Gasentladung ist.

16. Plasmaverfahren zur Oberflächenbehandlung von Substraten aus Silikon nach einem der Ansprüche 1 bis 15,
**dadurch gekennzeichnet, daß**
die Gasentladung in Gegenwart eines aus der Gruppe bestehend aus Ar, Ne, Kr, Xe ausgewählten Edelgases und gegebenenfalls eines Reaktivgases, umfassend ein Stickstoff-, Kohlenstoff- und/oder Sauerstoff-enthaltendes Gas, durchgeführt wird.

17. Plasmaverfahren zur Oberflächenbehandlung von Substraten aus Silikon nach Anspruch 16,
**dadurch gekennzeichnet, daß**
das Stickstoff-enthaltende Gas Stickstoff ist.

18. Plasmaverfahren zur Oberflächenbehandlung von Substraten aus Silikon nach Anspruch 16,
**dadurch gekennzeichnet, daß**
das Kohlenstoff-enthaltende Gas ausgewählt ist aus der Gruppe bestehend aus Kohlendioxid, Ethan, Ethylen und Acetylen.

19. Plasmaverfahren zur Oberflächenbehandlung von Substraten aus Silikon nach einem der Ansprüche 16 bis 18,
**dadurch gekennzeichnet, daß**
das Edelgas Ar und das Reaktivgas eine Mischung aus Stickstoff und Acetylen ist.

20. Plasmaverfahren zur Oberflächenbehandlung von Substraten aus Silikon nach einem der Ansprüche 16 bis 18,
**dadurch gekennzeichnet, daß**
das Edelgas Ar und das Reaktivgas eine Mischung aus Stickstoff und Kohlendioxid ist.

21. Plasmaverfahren zur Oberflächenbehandlung von Substraten aus Silikon nach einem der Ansprüche 16 bis 18,
**dadurch gekennzeichnet, daß**
das Edelgas Ar und das Reaktivgas Kohlendioxid ist.

22. Plasmaverfahren zur Oberflächenbehandlung von Substraten aus Silikon nach einem der Ansprüche 16 bis 18,
**dadurch gekennzeichnet, daß**
das Edelgas Ar und das Reaktivgas Acetylen ist.

23. Plasmaverfahren zur Oberflächenbehandlung von Substraten aus Silikon nach einem der Ansprüche 16 bis 18,
**dadurch gekennzeichnet, daß**
das Edelgas Ar und das Reaktivgas Stickstoff ist.

24. Plasmaverfahren zur Oberflächenbehandlung von Substraten aus Silikon nach einem der Ansprüche 16 bis 23,
**dadurch gekennzeichnet, daß**
die Gasentladung in Gegenwart von 30 bis 100 Vol.-% eines aus der Gruppe bestehend aus Ar, Ne, Kr, Xe ausgewählten Edelgases und 70 bis 0 Vol.-% eines Reaktivgases, umfassend ein Stickstoff-, Kohlenstoff- und/oder Sauerstoff-enthaltendes Gas, durchgeführt wird.

25. Plasmaverfahren zur Oberflächenbehandlung von Substraten aus Silikon nach Anspruch 24,
**dadurch gekennzeichnet, daß**
die Gasentladung in Gegenwart von 40 bis 80 Vol.-% Ar und 60 bis 20 Vol.-% eines Reaktivgases, umfassend ein Stickstoff-, Kohlenstoff- und/oder Sauerstoff-enthaltendes Gas, durchgeführt wird.

26. Plasmaverfahren zur Oberflächenbehandlung von Substraten aus Silikon nach einem der Ansprüche 1 bis 25,
**dadurch gekennzeichnet, daß**
die Gasentladung in einer Plasmaquelle erfolgt, das Edelgas kontinuierlich der Plasmaquelle zugeführt wird, das Reaktivgas, falls vorhanden, direkt in die Plasmaquelle eingeleitet wird und die Gase kontinuierlich mittels Vakuumpumpen aus der Prozesskammer abgepumpt werden.

27. Plasmaverfahren zur Oberflächenbehandlung von Substraten aus Silikon nach einem der Ansprüche 1 bis 26,
**dadurch gekennzeichnet, daß**
das aktivierte Substrat eine Oberflächenenergie von größer als 40 mN/m aufweist.

28. Plasmaverfahren zur Oberflächenbehandlung von Substraten aus Silikon nach einem der Ansprüche 1 bis 27,
**dadurch gekennzeichnet, daß**
das oberflächenbehandelte Substrat aus Silikon direkt beschichtet werden kann.

29. Plasmaverfahren zur Oberflächenbehandlung von Substraten aus Silikon nach Anspruch 28,
**dadurch gekennzeichnet, daß**
das oberflächenbehandelte Substrat durch eine Lackierung beschichtet werden kann.

30. Plasmaverfahren zur Oberflächenbehandlung von Substraten aus Silikon nach Anspruch 28,
**dadurch gekennzeichnet, daß**
das oberflächenbehandelte Substrat durch eine Metallisierung unter Verwendung eines PVD-Verfahrens beschichtet werden kann.

31. Plasmaverfahren zur Oberflächenbehandlung von Substraten aus Silikon nach Anspruch 30,
**dadurch gekennzeichnet, daß**
das PVD-Verfahren durch Sputtern erfolgt.

## Claims

1. Plasma process for the surface treatment of substrates of silicone, wherein the substrate to be treated is introduced into a process chamber, the substrate is outgassed, the outgassed gases are pumped continuously out of the process chamber by means of vacuum pumps, and the substrate is activated by plasma activation by exposing the surface of the substrate to a plasma produced by an electric gas discharge in vacuo, the energy and the duration of action of the plasma on the surface of the substrate being so selected that the surface energy of the substrate surface is increased significantly as a result of the modification of molecules close to the surface, it being possible for the substrates of silicone surface treated in this manner to be coated directly,
**characterised in that**
the plasma activation is carried out at a pressure of from 10⁻³ to 10⁻² mbar.

2. Plasma process for the surface treatment of substrates of silicone according to claim 1,
**characterised in that**
the substrate consists of flexible silicone.

3. Plasma process for the surface treatment of substrates of silicone according to claim 2,
**characterised in that**
the flexible silicone is dimethylsiloxane.

4. Plasma process for the surface treatment of substrates of silicone according to any one of claims 1 to 3,
**characterised in that**
the substrate is outgassed at a pressure of from 10⁻⁵ to 10⁻¹ mbar.

5. Plasma process for the surface treatment of substrates of silicone according to claim 4,
**characterised in that**
the substrate is outgassed at a pressure of from 10⁻⁴ to 10⁻² mbar.

6. Plasma process for the surface treatment of substrates of silicone according to any one of claims 1 to 5,
**characterised in that**
the substrate is outgassed for a period of from 3 to 60 minutes.

7. Plasma process for the surface treatment of substrates of silicone according to claim 6,
**characterised in that**
the substrate is outgassed for a period of from 10 to 30 minutes.

8. Plasma process for the surface treatment of substrates of silicone according to any one of claims 1 to 7,
**characterised in that**
the substrate is outgassed at a temperature of from 20°C to 100°C.

9. Plasma process for the surface treatment of substrates of silicone according to claim 8,
**characterised in that**
the substrate is outgassed at a temperature of from 30°C to 60°C.

10. Plasma process for the surface treatment of substrates of silicone according to any one of claims 1 to 9,
**characterised in that**
the plasma activation is carried out for a period of from 1 to 30 minutes.

11. Plasma process for the surface treatment of substrates of silicone according to claim 10,
**characterised in that**
the plasma activation is carried out for a period of from 5 to 15 minutes.

12. Plasma process for the surface treatment of substrates of silicone according to any one of claims 1 to 11,
**characterised in that**
the plasma activation is carried out at a temperature of from 20°C to 100°C.

13. Plasma process for the surface treatment of substrates of silicone according to claim 12,
**characterised in that**
the plasma activation is carried out at a temperature of from 30°C to 60°C.

14. Plasma process for the surface treatment of substrates of silicone according to any one of claims 1 to 13,
**characterised in that**
the gas discharge is a DC, AC, HF, RF or microwave gas discharge.

15. Plasma process for the surface treatment of substrates of silicone according to claim 14,
**characterised in that**
the gas discharge is a DC gas discharge.

16. Plasma process for the surface treatment of substrates of silicone according to any one of claims 1 to 15,
**characterised in that**
the gas discharge is carried out in the presence of a noble gas selected from the group consisting of Ar, Ne, Kr and Xe and optionally in the presence of a reactive gas comprising a nitrogen-, carbon- and/or oxygen-containing gas.

17. Plasma process for the surface treatment of substrates of silicone according to claim 16,
**characterised in that**
the nitrogen-containing gas is nitrogen.

18. Plasma process for the surface treatment of substrates of silicone according to claim 16,
**characterised in that**
the carbon-containing gas is selected from the group consisting of carbon dioxide, ethane, ethylene and acetylene.

19. Plasma process for the surface treatment of substrates of silicone according to any one of claims 16 to 18,
**characterised in that**
the noble gas is Ar and the reactive gas is a mixture of nitrogen and acetylene.

20. Plasma process for the surface treatment of substrates of silicone according to any one of claims 16 to 18,
**characterised in that**
the noble gas is Ar and the reactive gas is a mixture of nitrogen and carbon dioxide.

21. Plasma process for the surface treatment of substrates of silicone according to any one of claims 16 to 18,
**characterised in that**
the noble gas is Ar and the reactive gas is carbon dioxide.

22. Plasma process for the surface treatment of substrates of silicone according to any one of claims 16 to 18,
**characterised in that**
the noble gas is Ar and the reactive gas is acetylene.

23. Plasma process for the surface treatment of substrates of silicone according to any one of claims 16 to 18,
**characterised in that**
the noble gas is Ar and the reactive gas is nitrogen.

24. Plasma process for the surface treatment of substrates of silicone according to any one of claims 16 to 23,
**characterised in that**
the gas discharge is carried out in the presence of from 30 to 100 vol.% of a noble gas selected from the group consisting of Ar, Ne, Kr and Xe and from 70 to 0 vol.% of a reactive gas comprising a nitrogen-, carbon- and/or oxygen-containing gas.

25. Plasma process for the surface treatment of substrates of silicone according to claim 24,
**characterised in that**
the gas discharge is carried out in the presence of from 40 to 80 vol.% Ar and from 60 to 20 vol.% of a reactive gas comprising a nitrogen-, carbon- and/or oxygen-containing gas.

26. Plasma process for the surface treatment of substrates of silicone according to any one of claims 1 to 25,
**characterised in that**
the gas discharge takes place in a plasma source, the noble gas is supplied continuously to the plasma source, the reactive gas, where present, is fed directly into the plasma source, and the gases are pumped continuously out of the process chamber by means of vacuum pumps.

27. Plasma process for the surface treatment of substrates of silicone according to any one of claims 1 to 26,
**characterised in that**
the activated substrate has a surface energy greater than 40 mN/m.

28. Plasma process for the surface treatment of substrates of silicone according to any one of claims 1 to 27,
**characterised in that**
the surface-treated substrate of silicone can be coated directly.

29. Plasma process for the surface treatment of substrates of silicone according to claim 28,
**characterised in that**
the surface-treated substrate can be coated by lacquering.

30. Plasma process for the surface treatment of substrates of silicone according to claim 28,
**characterised in that**
the surface-treated substrate can be coated by metallisation using a PVD process.

31. Plasma process for the surface treatment of substrates of silicone according to claim 30,
**characterised in that**
the PVD process is carried out by sputtering.

## Revendications

1. Procédé de traitement de surface par plasma de substrats de silicone, le substrat à traiter étant introduit dans une chambre de processus, le substrat étant dégazé, les émanations étant pompées en continu hors de la chambre de processus au moyen de pompes à vide, et le substrat étant activé par activation plasma, tandis que la surface du substrat est exposée au plasma produit dans le vide par une décharge électrique gazeuse, l'énergie et la durée d'action du plasma sur la surface du substrat étant choisies de manière à ce que l'énergie surfacique de la surface du substrat soit augmentée significativement en raison de la modification de molécules proches de la surface, les substrats de silicone traités en surface de cette façon pouvant être recouverts directement,
**caractérisé en ce que**
l'activation plasma s'effectue à une pression allant de 10⁻³ à 10⁻² mbar.

2. Procédé de traitement de surface par plasma de substrats de silicone selon la revendication 1,
**caractérisé en ce que**
le substrat se compose de silicone flexible.

3. Procédé de traitement de surface par plasma de substrats de silicone selon la revendication 2,
**caractérisé en ce que**
la silicone flexible est du diméthylsiloxane.

4. Procédé de traitement de surface par plasma de substrats de silicone selon l'une quelconque des revendications 1 à 3, **caractérisé en ce que**
le substrat est dégazé à une pression allant de 10⁻⁵ à 10⁻¹ mbar.

5. Procédé de traitement de surface par plasma de substrats de silicone selon la revendication 4,
**caractérisé en ce que**
le substrat est dégazé à une pression allant de 10⁻⁴ à 10⁻² mbar.

6. Procédé de traitement de surface par plasma de substrats de silicone selon l'une quelconque des revendications 1 à 5,
**caractérisé en ce que**
la durée de dégazage du substrat va de 3 à 60 minutes.

7. Procédé de traitement de surface par plasma de substrats de silicone selon la revendication 6,
**caractérisé en ce que**
la durée du dégazage du substrat va de 10 à 30 minutes.

8. Procédé de traitement de surface par plasma de substrats de silicone selon l'une quelconque des revendications 1 à 7,
**caractérisé en ce que**
le substrat est dégazé à une température allant de 20°C à 100°C.

9. Procédé de traitement de surface par plasma de substrats de silicone selon la revendication 8,
**caractérisé en ce que**
le substrat est dégazé à une température allant de 30°C à 60°C.

10. Procédé de traitement de surface par plasma de substrats de silicone selon l'une quelconque des revendications 1 à 9,
**caractérisé en ce que**
la durée de l'activation plasma va de 1 à 30 minutes.

11. Procédé de traitement de surface par plasma de substrats de silicone selon la revendication 10,
**caractérisé en ce que**
la durée de l'activation plasma va de 5 à 15 minutes.

12. Procédé de traitement de surface par plasma de substrats de silicone selon l'une quelconque des revendications 1 à 11,
**caractérisé en ce que**
l'activation plasma a lieu à une température allant de 20°C à 100°C.

13. Procédé de traitement de surface par plasma de substrats de silicone selon la revendication 12,
**caractérisé en ce que**
l'activation plasma a lieu à une température allant de 30°C à 60°C.

14. Procédé de traitement de surface par plasma de substrats de silicone selon l'une quelconque des revendications 1 à 13,
**caractérisé en ce que**
la décharge gazeuse est une décharge gazeuse en courant continu, en courant alternatif, à hautes fréquences, en radio-fréquences ou en micro-ondes.

15. Procédé de traitement de surface par plasma de substrats de silicone selon la revendication 14,
**caractérisé en ce que**
la décharge gazeuse est une décharge gazeuse en courant continu.

16. Procédé de traitement de surface par plasma de substrats de silicone selon l'une quelconque des revendications 1 à 15,
**caractérisé en ce que**
la décharge gazeuse est effectuée en présence d'un gaz noble choisi parmi le groupe constitué de Ar, Ne, Kr, Xe et, le cas échéant, d'un gaz réactif comprenant un gaz contenant de l'azote, du carbone et/ou de l'oxygène.

17. Procédé de traitement de surface par plasma de substrats de silicone selon la revendication 16,
**caractérisé en ce que**
le gaz contenant de l'azote est de l'azote.

18. Procédé de traitement de surface par plasma de substrats de silicone selon la revendication 16,
**caractérisé en ce que**
le gaz contenant du carbone est choisi parmi le groupe constitué de dioxyde de carbone, d'éthane, d'éthylène et d'acétylène.

19. Procédé de traitement de surface par plasma de substrats de silicone selon l'une quelconque des revendications 16 à 18,
**caractérisé en ce que**
le gaz noble est de l'Ar et le gaz réactif est un mélange d'azote et d'acétylène.

20. Procédé de traitement de surface par plasma de substrats de silicone selon l'une quelconque des revendications 16 à 18,
**caractérisé en ce que**
le gaz noble est de l'Ar et le gaz réactif est un mélange d'azote et de dioxyde de carbone.

21. Procédé de traitement de surface par plasma de substrats de silicone selon l'une quelconque des revendications 16 à 18,
**caractérisé en ce que**
le gaz noble est de l'Ar et le gaz réactif est du dioxyde de carbone.

22. Procédé de traitement de surface par plasma de substrats de silicone selon l'une quelconque des revendications 16 à 18,
**caractérisé en ce que**
le gaz noble est de l'Ar et le gaz réactif est de l'acétylène.

23. Procédé de traitement de surface par plasma de substrats de silicone selon l'une quelconque des revendications 16 à 18,
**caractérisé en ce que**
le gaz noble est de l'Ar et le gaz réactif est de l'azote.

24. Procédé de traitement de surface par plasma de substrats de silicone selon l'une quelconque des revendications 16 à 23,
**caractérisé en ce que**
la décharge gazeuse est effectuée en présence de 30 jusqu'à 100 % en volume d'un gaz noble choisi parmi le groupe constitué de Ar, Ne, Kr, Xe et de 70 jusqu'à 0 % en volume d'un gaz réactif comprenant un gaz contenant de l'azote, du carbone et/ou de l'oxygène.

25. Procédé de traitement de surface par plasma de substrats de silicone selon la revendication 24,
**caractérisé en ce que**
la décharge gazeuse est effectuée en présence de 40 jusqu'à 80 % en volume d'Ar et de 60 jusqu'à 20 % en volume d'un gaz réactif comprenant un gaz contenant de l'azote, du carbone et/ou de l'oxygène.

26. Procédé de traitement de surface par plasma de substrats de silicone selon l'une quelconque des revendications 1 à 25,
**caractérisé en ce que**
la décharge gazeuse a lieu dans une source de plasma, le gaz noble est acheminé en continu à la source de plasma, le gaz réactif, s'il est présent, est introduit directement dans la source de plasma, et les gaz sont pompés en continu hors de la chambre de processus au moyen de pompes à vide.

27. Procédé de traitement de surface par plasma de substrats de silicone selon l'une quelconque des revendications 1 à 26,
**caractérisé en ce que**
le substrat activé présente une énergie surfacique supérieure à 40 mN/m.

28. Procédé de traitement de surface par plasma de substrats de silicone selon l'une quelconque des revendications 1 à 27,
**caractérisé en ce que**
le substrat de silicone traité en surface peut être recouvert directement.

29. Procédé de traitement de surface par plasma de substrats de silicone selon la revendication 28,
**caractérisé en ce que**
le substrat traité en surface peut être recouvert par un laquage.

30. Procédé de traitement de surface par plasma de substrats de silicone selon la revendication 28,
**caractérisé en ce que**
le substrat traité en surface peut être recouvert par une métallisation en utilisant un procédé PVD.

31. Procédé de traitement de surface par plasma de substrats de silicone selon la revendication 30,
**caractérisé en ce que**
le procédé PVD se fait par pulvérisation.
